Europäisches Patentamt

(19) European Patent Office

Office européen des brevets

(11) Publication number: **0 019 222**
**B1**

(12) **EUROPEAN PATENT SPECIFICATION**

(45) Date of publication of patent specification: **11.04.84**

(21) Application number: **80102535.4**

(22) Date of filing: **08.05.80**

(51) Int. Cl.³: **H 02 H 7/20, H 02 J 9/06, G 11 C 7/00, G 06 F 1/00**

(54) Circuit for electrically connecting a volatile memory to a power supply input terminal.

(30) Priority: **15.05.79 US 39249**

(43) Date of publication of application:
**26.11.80 Bulletin 80/24**

(45) Publication of the grant of the patent:
**11.04.84 Bulletin 84/15**

(84) Designated Contracting States:
**AT BE CH DE FR GB IT LI NL SE**

(56) References cited:
**DE - A - 2 415 029**
**DE - A - 2 609 428**
**US - A - 3 859 638**

(73) Proprietor: **MOSTEK CORPORATION**
**1215 West Crosby Road**
**Carrollton Dallas, Texas 75006 (US)**

(72) Inventor: **Donnelly, Robert Murray**
**2911 Country Place Ct.**
**Carrollton, Texas (US)**

(74) Representative: **Patentanwälte Dipl.-Ing. A. Grünecker, Dr.-Ing. H. Kinkeldey, Dr.-Ing. W. Stockmair,**
**Dr. rer. nat. K. Schumann, Dipl.-Ing. P.H. Jakob, Dr. rer. nat. G. Bezold Maximilianstrasse 58 D-8000 München 22 (DE)**

Courier Press, Leamington Spa, England.

Circuit for electrically connecting a volatile memory to a power supply input terminal

The present invention relates to a circuit in accordance with the generic clause of the main claim.

DE—A1—24 15 029 disclosed a circuit having the features of the generic clause of the main claim. This prior art circuit comprises a control circuit, which measures the voltage of a primary power source for deciding, whether the voltage of this source is sufficient for the power supply of the memory. If the voltage is sufficient, the control circuit connects the memory with the primary power source. If it is not sufficient, the primary power source is disconnected from the memory and simultaneously an auxiliary power source is connected to the memory. This prior art circuit is not adapted for being used as a part of an integrated circuit having a predetermined number of input pins in accordance with industry standard connector sockets, as it requires additional input lines for the connecting of the circuitry with an auxiliary power source.

The present invention is based on the technical problem how to provide a circuit in accordance with the generic clause of the main claim ensuring a reliable operation of the memory even when the voltage fed to the power supply input terminal is below a predetermined threshold, and which is adapted to industry standard connector sockets.

This technical problem is solved by a circuit in accordance with the generic clause of the main claim having the features of the characterising part of the main claim.

The present invention is based on the technical idea of using one input pin of the integrated circuit for two different functions. An input signal pin is connected with the second field effect transistor such that the signal input terminal can be used for both, for feeding an input signal to the integrated circuit and for feeding the supply voltage of the auxiliary power source to the integrated circuit. When the voltage of the power supply input terminal is below a predetermined threshold, the terminal and the peripheral circuit connected to the terminal is disconnected from the memory which is simultaneously connected with the signal input terminal. Thus, the inventive circuit is adapted for ensuring a reliable operation of the memory without increasing its number of terminals so that this integrated circuit is compatible with standard industry sockets.

A further advantage of the claimed invention is that a power drain in peripheral drive circuits is prevented during the standby mode of operation, that means, during the supply of the memory by means of the auxiliary power source.

According to the claimed invention, power drain in the peripheral drive circuits is totally eliminated in the standby operating condition by decoupling the memory array power input node with respect to the external power input pin whereby only the volatile memory cells are supplied by the auxiliary source, while the peripheral control circuits remain connected to the external power source.

Auxiliary power for the volatile memory cells is conducted to the memory cell power input node through an existing external control signal pin, such as the $\overline{CS}$ input pin, thereby eliminating the need for additional connector pins. The auxiliary power source is coupled to the external control signal pin through a diode which is forward biased only when the primary power source potential drops below the auxiliary power source level, thereby avoiding masking of the applied control signal $\overline{CS}$.

The control signal input pin is coupled to the memory array power input node through a field effect transistor switch which is turned on only when the voltage level at the control signal input pin exceeds the voltage on the memory array power input mode by a predetermined threshold voltage level. The external power input pin is similarily coupled to the memory array power input node through a field effect transistor switch which is turned on only when the voltage applied to the external power input pin exceeds the memory array power input node voltage by a predetermined threshold value.

Whilst operating power is being conducted through the external power input pin from the primary power source, the control signal input to which the auxiliary power source is coupled will function normally since the auxiliary source is blocked by the back-biased diode. However, when the primary power source falls below the level required for reliable operation, the memory array power input node is automatically disconnected from the external power input pin by the operation of the field effect transistor switch, which is turned off. This simultaneously decouples the memory array power input node from the peripheral drive circuit. At the same time, the diode becomes forward biased as the voltage level of the primary source drops, thereby applying the auxiliary power source to the control circuit input pin. Data retention operating current is conducted from the auxiliary source to the memory array power input node through the second transistor switch which turns on in response to the reduced potential at the memory array power input node.

One way of carrying out the invention is described in detail below with reference to a drawing which illustrates a preferred embodiment, in which:

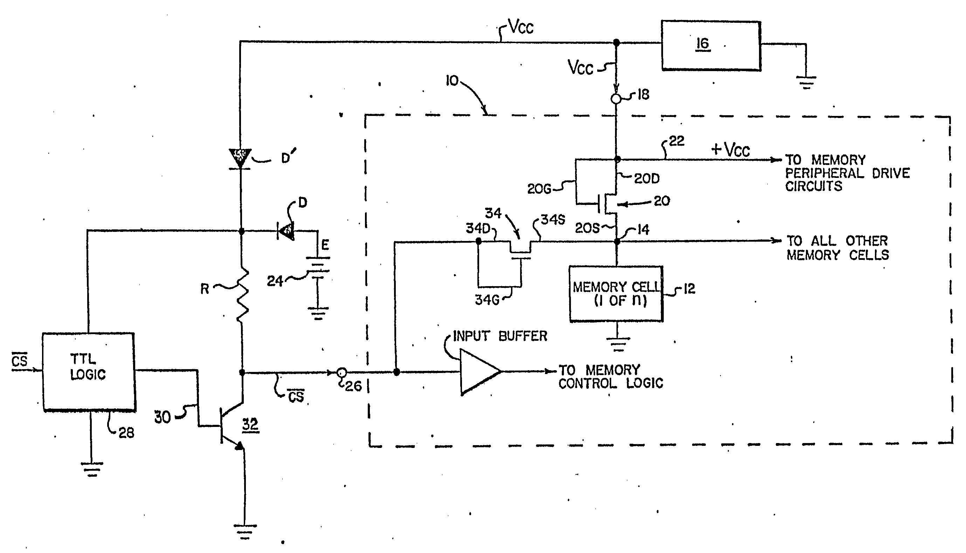

the sole figure of the drawing is a circuit diagram which illustrates a specific embodiment of the present invention.

Referring now to the drawing, an integrated circuit memory system, forming a part of a micro-processor, is indicated generally by the reference numeral 10. The system 10 is preferably fabricated using conventional LSI process technology to produce enhancement mode MOS—FET devices on a semiconductor substrate chip. The integrated circuit memory system is a random access memory having a total of $n$ binary volatile storage cells arrayed in an MXN matrix of rows and columns. Each storage cell, for example volatile cell 12, comprises a field of effect transistor and a capacitor (not shown). Each memory cell is coupled to row and column lines in the usual manner, and includes read/write circuitry (not shown) and precharge circuitry (not shown) which conducts operating current to the storage capacitor of each cell through a power input node 14, which is common to each cell of the array.

Primary operating power is supplied by an external power source 16 and delivers a nominal operating voltage $V_{cc}$ to an external input pin 18. The nominal value of voltage $V_{22}$ is plus 5 volts DC.

According to an important feature of the invention, the memory peripheral drive circuits which do not involve volatile storage devices are connected directly to the external power input pin 18, and the volatile components, e.g., the memory cells 12, are coupled indirectly to the external power input pin 18 through an enhancement mode field effect transistor 20. The field effect transistor 20 is connected to operate as a switch, with its gate 20G and drain 20D both being connected to the external power input pin 18. It source 20S is connected to the memory array power input node 14.

To understand the operation of the field effect transistor 20, assume that a potential of $V_{cc}$ equal to +5 volts is applied to the external power input pin 18, and that the operating threshold of the enhancement mode transistor 20 is about 2 volts. Therefore, the potential on the source 20S and also on the memory array power input node 14 will be 3 volts, a level which is sufficient to insure reliable operation of the volatile memory cells.

According to an important feature of the invention, memory peripheral drive circuits (not shown) are energized by direct connection to the external power input pin 18. The memory peripheral drive circuits are each connected directly to the external power input pin 18 by a power conductor 22. By this arrangement, the memory peripheral drive circuits are connected in parallel electrical circuit relation with the transistor 20, whereby the memory peripheral drive circuits are automatically disconnected with respect to the memory array power input node 14 when the transistor 20 turns off in response to a low voltage condition. This allows the memory cells 12 to be supplied from an auxiliary power source 24 without imposing an unnecessary drain on the capacity of the auxiliary power source.

To be compatible with industry standard pin socket connectors, the auxiliary power source 24 must be coupled to the memory array power input node 14 without requiring an additional external connector pin. This is achieved in to the present invention by utilizing an existing pin, for example pin 26 which is connected to the chip select complement signal $\overline{CS}$, which is generated in some other part of the micro-processor. The auxiliary power source 24 must be coupled to the signal $\overline{CS}$ pin 26 in such a manner that it is decoupled with respect to the pin except during the data retention backup mode of operation. The chip select complement signal $\overline{CS}$ will assume the logic high condition $(V_{cc})$ when the chip 10 is "unselected", and will assume the logic low (ground or zero potential) when the chip 10 is selected.

Under ordinary operating conditions, the complement chip select signal $\overline{CS}$ is generated in some other portion of the micro-processor and is applied to the control circuit input pin 26 through a logic circuit 28 and bi-polar transistor 32. The logic circuit 28 develops a gate signal 30 which turns the bi-polar transistor 32 off and on as signal $\overline{CS}$ assumes the logic 1 and the logic 0 conditions, respectively. The collector of the bi-polar transistor 32 is coupled to $V_{cc}$ through a load resistor R, and the collector is also connected directly to the control circuit input pin 26 so that the potential on the collector of the bi-polar transistor 32 will swing from $V_{cc}$ to ground potential as the compliment chip selects signal $\overline{CS}$ changes state from logic 1 to logic 0, respectively.

The auxiliary power source 24 is connected in parallel circuit relation with the primary external power source so that it can supply operating current upon failure of $V_{cc}$. Connected in series electrical relation with the auxiliary power source 24 is a junction diode D. The nominal voltage level of the auxiliary power source 24 is deliberately chosen to be less than the nominal voltage level of $V_{22}$, whereby the junction diode D is back-biased during ordinary operating conditions. A second diode D' interconnected between the load resistor R and the terminal 18 prevents a current flow from the auxiliary power source 24 to the terminal 18, if the voltage of auxiliary power source 24 is greater than the voltage of the primary power source 16. However, when the $V_{cc}$ voltage level drops below the voltage level of the auxiliary power source 24, the diode D becomes forward biased and conducts current from the auxiliary power source 24 through the load resistor R.

Recalling that the only operating condition of interest is the case with the chip 10 unselected and $V_{cc}$ below the minimum level required for reliable operation, the bi-polar transistor 32 will be turned off, thereby causing its collector to rise to the voltage level E of the auxiliary power source 24. Assuming that $V_{cc}$ has a nominal voltage level of 5 volts DC, and the E equals 4.5 volts, as the $V_{cc}$ drops below 4.5 volts, the diode D will conduct and a voltage of E = 4.5 volts will be impressed across the control circuit input pin 26.

Current from the auxiliary power source 24 is conducted to the memory array power input node 14 through a second enhancement mode field effect transistor 34 which has its drain 34D and gate 34G connected to the control signals $\overline{CS}$ input pin 26, and its source 34S connected to the memory array power input node 14. Assuming that the threshold potential of the field effect transistor 34 is approximately 2 volts, it will turn on when the voltage of the memory array power input node 14 falls below 2.5 volts. Thus the transistor switch 34 will turn on and supply data retention current to the memory cell 12 well in advance of the point that the field effect transistor 20 turns off, thereby assuring continuity of data retention operating current. Moreover, as the field effect transistor 20 turns off, the peripheral drive circuits are decoupled from the memory array.

## Claims

1. Circuit for electrically connecting a volatile memory (12) to a power supply input terminal (18) if the voltage of this terminal (18) is above a predetermined threshold and for disconnecting the memory (12) from the terminal (18) and connecting it to an auxiliary power supply (24), if the voltage is below the predetermined threshold, characterised in that the circuit is an integrated circuit (10) containing the memory (12) having a plurality of memory cells (12), the power supply input terminal (18) and a signal input terminal (26),

that the power supply input terminal (18) is connected to a peripheral circuitry,

that the auxiliary power supply (24) is electrically connectable to the signal input terminal (26),

that the integrated circuit (10) comprises a first field effect transistor (20) having its gate (20G) and a drain (20D) connected to the power supply terminal (18), and

that it comprises a second field effect transistor (34) having its gate (34G) and drain (34D) connected to the signal input terminal (26) and its source (34S) connected to a source (20S) of the first field effect transistor (20) and to a power supply input of at least one of a plurality of memory cells (12).

2. Circuit as claimed in claim 1, characterised in that the difference between the nominal voltage level of a primary power source (16) and the switching threshold of the first field effect transistor (20) is greater than the difference between the nominal voltage level of the auxiliary power source (24) and the switching threshold of the second field effect transistor (34).

3. Circuit according to claim 1 or 2, characterised in that the nominal voltage level of the auxiliary power source (24) is less than the nominal voltage level of the primary power source (16).

## Revendications

1. Circuit pour connecter électriquement une mémoire non rémanente (12) à une borne (18) d'entrée d'alimentation si la tension de cette borne (18) est supérieure à un seuil prédéterminé et pour déconnector la mémoire (12) de la borne (18) et la connector à une source (24) d'alimentation auxiliaire, si la tension est inférieure au seuil prédéterminé, caractérisé en ce que le circuit est un circuit intégré (10) contenant la mémoire (12) qui comporte une pluralité de cellules de mémoire (12), la borne (18) d'entré d'alimentation et une borne (26) d'entrée de signal,

la borne (18) d'entrée d'alimentation est connectée à un circuit périphérique,

l'alimentation auxiliaire (24) peut être connectée électriquement à la borne (26) d'entrée de signal,

le circuit intégré (10) comprend un premier transistor à effet de champ (20) ayant sa porte (20G) et son drain (20D) connectés à la borne (18) d'alimentation, et

le circuit (10) comprend un second transistor à effet de champ (34) ayant sa porte (34G) et son drain (34D) connectés au signal (26) d'entrée de signal et sa source (34S) connectée à une source (20S) du premier transistor à effet de champ (20) et à une entrée d'alimentation d'au moins une cellule de la pluralité de cellules de mémoire (12).

2. Circuit selon la revendication 1, caractérisé en ce que la différence entre le niveau nominal de tension d'une source d'alimentation primaire (16) et le seuil de commutation du premier transistor à effet de champ (20) est supérieure à la différence entre le niveau nominal de tension de la source d'alimentation auxiliaire (24) et le seuil de commutation du second transistor à effet de champ (34).

3. Circuit selon la revendication 1 ou 2, caractérisé en ce que le niveau nominal de tension de la source d'alimentation auxiliaire (24) est inférieur au niveau nominal de tension de la source d'alimentation primaire (16).

## Patentansprüche

1. Schaltung zum elektrischen Verbinden eines flüchtigen Speichers (12) mit einer Leistungsversorgungs-Eingangsklemme (18), wenn die Spannung dieser Klemme (18) oberhalb einer vorbestimmten Schwelle ist, und zum Trennen des Speichers (12) von der Klemme (18) und zum Verbinden von diesem mit einer Hilfsleistungsversorgung (24), wenn die Spannung unterhalb der vorbestimmten Schwelle ist, dadurch gekennzeichnet, daß die Schaltung eine integrierte Schaltung (10) ist, die einen Speicher (12) mit einer Mehrzahl von Speicherzellen (12), die Leistungsversorgungs-Eingangsklemme (18) und eine Signal-Eingangsklemme (26) enthält,

daß die Leistungsversorgungs-Eingangsklemme (18) mit einer äußeren Schaltung verbunden ist,

daß die Hilfsleistungsversorgung (24) elektrisch mit der Signal-Eingangsklemme (26) verbindbar ist, daß die integrierte Schaltung (10) einen ersten Feldeffekttransistor (20) enthält, dessen Gate (20G) und dessen Drain (20D) mit der Leistungsversorgungsklemme (18) verbunden ist, und

daß sie einen zweiten Feldeffekttransistor (34) enthält, dessen Gate (34G) un dessen Drain (34D) mit der Signal-Eingangsklemme (26) und dessen Source (34S) mit einer Source (20S) des ersten Feldeffekttransistors (20) und mit einem Leistungsversorgungseingang von wenigstens einer Speicherzelle der Mehrzahl von Speicherzellen (12) verbunden ist.

2. Schaltung nach Anspruch 1, dadurch gekennzeichnet, daß die Differenz zwischen dem Nennspannungspegel einer ersten Leistungsquelle (16) und der Schaltschwelle des ersten Feldeffekttransistors (20) größer ist als die Differenz zwischen der Nennspannungspegel der Hilfsleistungsquelle (24) und der Schaltschwelle des zweiten Feldeffekttransistors (34).

3. Schaltung nach Anspruch 1 oder 2, dadurch gekennzeichnet, daß der Nennspannungspegel der Hilfsleistungsquelle (24) niedriger ist als der Nennspannungspegel der ersten Leistungsquelle (16).